**Europäisches Patentamt**

**European Patent Office**

**Office européen des brevets**

(11) Veröffentlichungsnummer : **0 137 948**
**B1**

# EUROPÄISCHE PATENTSCHRIFT

(45) Veröffentlichungstag der Patentschrift :
02.03.88

(51) Int. Cl.⁴ : **G 01 R 29/027**, G 11 B 20/14

(21) Anmeldenummer : **84109513.6**

(22) Anmeldetag : **09.08.84**

(54) Schaltungsanordnung zum Überprüfen des zeitlichen Abstands von Rechtecksignalen.

(30) Priorität : 12.08.83 DE 3329242

(43) Veröffentlichungstag der Anmeldung :
24.04.85 Patentblatt 85/17

(45) Bekanntmachung des Hinweises auf die Patenterteilung : 02.03.88 Patentblatt 88/09

(84) Benannte Vertragsstaaten :
AT CH DE FR GB IT LI NL SE

(56) Entgegenhaltungen :
US-A- 3 395 355
US-A- 3 694 772

(73) Patentinhaber : Siemens Aktiengesellschaft Berlin
und München
Wittelsbacherplatz 2
D-8000 München 2 (DE)

(72) Erfinder : Fischer, Helmut, Dipl.-Ing.
Oertlinweg 6
D-8000 München 90 (DE)

**Beschreibung**

Die Erfindung bezieht sich auf eine Schaltungsanordnung zum Überprüfen des zeitlichen Abstands von Rechtecksignalen entsprechend dem
Oberbegriff des Patentanspruchs 1.

Zum Überprüfen des zeitlichen Abstands von
Rechtecksignalen, die aus ersten Rechtecksignalen und zwischen diesen auftretenden zweiten
Rechtecksignalen bestehen, ist es zweckmäßig,
mit jeweils einem ersten Rechtecksignal ein Zeitfenster zu erzeugen, das einen Erwartungszeitraum für jeweils ein zweites Rechtecksignal definiert. Zur Erzeugung des Zeitfensters wäre es
denkbar, zwei monostabile Kippstufen zu verwenden, von denen die erste den Beginn und die
zweite das Ende des Zeitfensters markiert. Eine
derartige Schaltungsanordnung erfordert einen
verhältnismäßig großen Aufwand und insbesondere ist ein Abgleich wegen der verhältnismäßig
großen Ungenauigkeiten der internen Widerstände von monostabilen Kippstufen erforderlich.

Der wohl am nächsten kommende Stand der
Technik ist aus dem Dokument US-A-3, 395, 355
bekannt. Dort ist eine Decodieranordnung mit
einem Diskriminator beschrieben, der auf variable
Zeitintervalle einstellbar ist. Es wird zwischen
Taktimpulsen und Datenimpulsen unterschieden,
die gemeinsam, jedoch zeitlich versetzt von einem
Magnetschichtspeicher gelesen werden. Dabei
wird vor allem auf eine Langzeitverschiebung der
Folgefrequenz der Taktimpulsreihe abgestellt.
Ein erkannter Taktimpuls startet einen Sägezahngenerator und steuert eine monostabile Kippstufe
an. Das Ausgangssignal dieser Kippstufe wird
mehrfach stufenweise integriert und zwischengespeichert, um einen gewichteten Durchschnittswert für die bisher aufgetretenen Zeitintervalle
zwischen aufeinanderfolgenden Taktimpulsen zu
bilden. In Form einer Bezugsspannung wird dieser Durchschnittswert einem Komparator zugeführt, der diesen Wert mit dem kontinuierlich
ansteigenden Ausgangssignal des Sägezahngenerators vergleicht. Ein Vergleich der Bezugsspannung mit diskreten, insbesondere wechselweise wirksamen Schwellenwerten ist nicht vorgesehen.

Sobald das Ausgangssignal des Sägezahngenerators größer ist als diese Bezugsspannung, wird
ein Schaltglied aktiviert, das die Eingangssignale
empfängt und im aktivierten Zustand einen empfangenen Impuls als Taktimpuls diskriminiert, der
wiederum den Sägezahngenerator rücksetzt und
erneut startet. Durch dieses Rücksetzen wird der
Komparator umgesteuert und infolgedessen das
Schaltglied deaktiviert. Der eingeschaltete Zustand des Schaltgliedes spiegelt damit im zeitlichen Verlauf ein Fenster wider, das den Erwartungszeitraum für den nächsten Taktimpuls angibt.

Mit der bekannten Schaltungsanordnung sind
wohl langsame Variationen der Folgefrequenz
aufzufangen, eine Diskriminierung des Eingangssignales hinsichtlich der Impulsform oder -amplitude findet jedoch nicht statt. Jeder Störimpuls,
wenn er nur scheinbar zeitlich « richtig » im
Zeitraster auftritt, wird als Nutzimpuls gewertet.
Darüber hinaus bringt ein ausfallender Nutzimpuls die Synchronisierung sofort außer Tritt, weil
der Sägezahngenerator solange weiterläuft bis
der nächste Taktimpuls « erkannt » ist. Die bekannte Schaltungsanordnung kann wohl langfristige Variationen der Folgefrequenz verarbeiten,
ist aber gegenüber kurzfristigen Störungen empfindlich und benötigt bei den heute üblichen
Aufzeichnungsdichten einen langen Zeitraum,
um sich zu resynchronisieren.

Der Erfindung liegt daher die Aufgabe zugrunde, eine Schaltungsanordnung zum Überprüfen
des zeitlichen Abstands von Rechtecksignalen
anzugeben, die bei geringem Aufwand auch Impulsform und/oder Amplitude der Eingangssignale diskriminiert und damit in die Lage versetzt ist,
kurzfristige Störungen zu verarbeiten und sich
schnell zu resynchronisieren.

Erfindungsgemäß wird die Aufgabe bei der
Schaltungsanordnung der eingangs genannten
Art durch die im kennzeichnenden Teil des Patentanspruchs 1 angegebenen Merkmale gelöst.

Die Schaltungsanordnung gemäß der Erfindung
hat den Vorteil, daß sie sehr kostengünstig aufgebaut werden kann. Sie kann insbesondere in
Form einer Dickschicht- oder Dünnfilmschaltung
kostengünstig aufgebaut werden.

Die Umschaltung der Schwellenwerte erfolgt
zweckmäßigerweise unter Verwendung eines umschaltbaren Spannungsteilers, der durch ein Verknüpfungsglied ohne Kollektorwiderstand des
Ausgangstransistors angesteuert wird. Das Integrierglied ist bei einer vorteilhaften Ausführungsform als Kondensator ausgebildet, der über einen
Widerstand aufgeladen wird und unter Verwendung eines integrierten Verknüpfungsglieds ohne
Kollektorwiderstand des Ausgangstransistors entladen wird.

Die Schaltungsanordnung erweist sich insbesondere dann als zweckmäßig, wenn die Rechtecksignale Impulse darstellen, die aus Lesesignalen eines Plattenspeichers abgeleitet werden und
dort insbesondere bei Lesesignalen, die Servotaktimpulse für die Positionierung von Magnetköpfen
auf dem Speichermedium darstellen.

Ein Ausführungsbeispiel der Schaltungsanordnung wird im folgenden anhand von Zeichnungen
näher erläutert. Es zeigen

Figur 1    ein Blockschaltbild der Schaltungsanordnung,

Figur 2    Zeitdiagramme von Signalen an verschiedenen Punkten der Schaltungsanordnung,

Figur 3    ein Ausführungsbeispiel der Schaltungsanordnung.

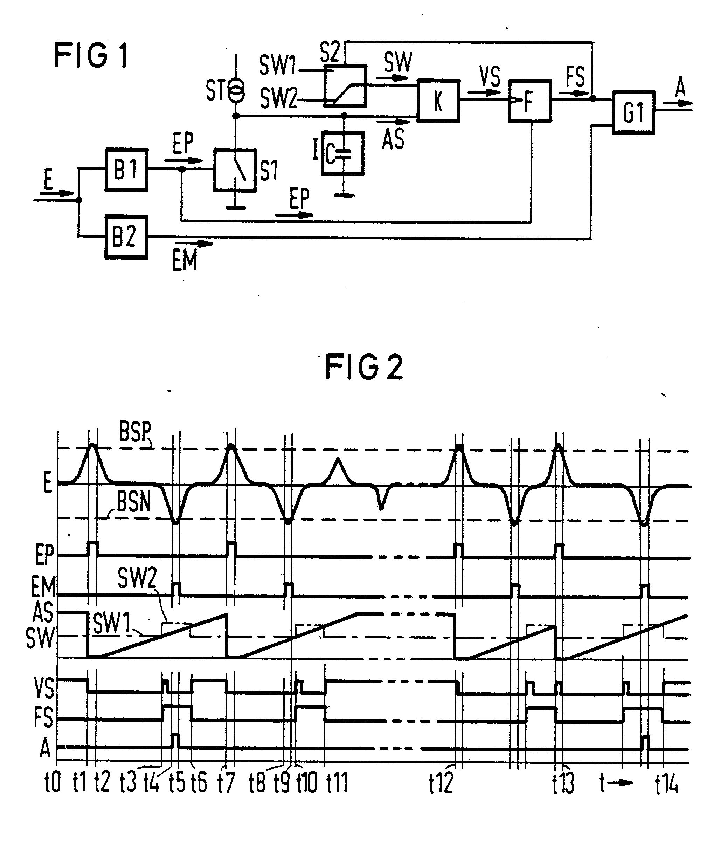

Die in Fig. 1 dargestellte Schaltungsanordnung
enthält zwei Bewerterstufen B1 und B2, denen
analoge Eingangssignale E zugeführt werden
und die erste Rechtecksignale EP und zweite
Rechtecksignale EM erzeugen. Weiterhin enthält die Schaltungsanordnung ein Integrierglied I, das einen über eine Stromquelle ST aufladbaren und über einen Schalter S1 entladbaren Kondensator C enthält. Der Kondensator C wird mit jedem Auftreten eines Rechtecksignals EP entladen. Die Spannung AS am Kondensator C wird in einem Komparator K mit einem umschaltbaren Schwellenwert SW verglichen. Die Umschaltung des Schwellenwerts SW zwischen einem Schwellenwert SW1 und einem Schwellenwert SW2 erfolgt unter Verwendung einer Schaltstufe S2. Dem Komparator K ist eine Ausgangsstufe bestehend aus einem Flipflop F und einem UND-Glied G1 nachgeschaltet. Das Ausgangssignal FS des Flipflops F steuert einerseits die Schaltstufe S2 und wird andererseits einem ersten Eingang des UND-Glieds G1 zugeführt wird, an dessen zweitem Eingang die Rechtecksignale EM anliegen. An seinem Ausgang gibt das UND-Glied G1 Ausgangssignale A immer dann ab, wenn die Rechtecksignale EM während eines unter Verwendung des Integrierglieds I, des Komparators K und des Flipflops F erzeugten Zeitfensters auftreten.

Weitere Einzelheiten der Schaltungsanordnung werden im folgenden zusammen mit den in Fig. 2 dargestellten Zeitdiagrammen beschrieben.

Bei den in Fig. 2 dargestellten Zeitdiagrammen sind in Abszissenrichtung die Zeit t und in Ordinatenrichtung die Signale an verschiedenen Punkten der Schaltungsanordnung dargestellt.

Die Eingangssignale E stellen beispielsweise Lesesignale beim Abtasten von Servotaktspuren eines Plattenspeichers dar. In den Bewerterstufen B1 und B2 werden die Rechtecksignale EP und EM erzeugt, wenn die Eingangssignale E vorgegebene Schwellenwerte BSP bzw. BSN über- bzw. unterschreiten.

Es wird davon ausgegangen, daß zum Zeitpunkt t0 der Kondensator C auf seinen maximalen Wert aufgeladen ist. Der Schwellenwert SW stimmt mit einem niederen Schwellenwert SW1 überein.

Zum Zeitpunkt t1 überschreitet das Eingangssignal E den Schwellenwert BSP, so daß für die kurze Zeitspanne t2-t1 ein Rechtecksignal EP erzeugt wird. Das Rechtecksignal EP schließt den Schalter S1, so daß der Kondensator C sehr schnell entladen wird. Außerdem setzt das Signal EP das Flipflop F zurück. Zum Zeitpunkt t2 ist das Rechtecksignal EP beendet und der Schalter S1 wird wieder geöffnet, so daß der Kondensator C entsprechend einer vorgegebenen Zeitkonstante langsam aufgeladen wird.

Zum Zeitpunkt t3 überschreitet die Spannung AS am Kondensator C den Schwellenwert SW1 und der Komparator K erzeugt ein Vergleichssignal VS, das das Flipflop F setzt. Das Signal FS am Ausgang des Flipflops F nimmt den Binärwert 1 an und schaltet in der Schaltstufe S2 den Schwellenwert SW2 zum Komparator K durch. Außerdem definiert das Signal FS den Erwartungszeitraum für die Rechtecksignale EM. Dieser Erwartungszeitraum beginnt mit dem Zeitpunkt t3 und endet mit dem Zeitpunkt t6, wenn die Spannung AS den Schwellenwert SW2 überschreitet und erneut ein Vergleichssignal VS erzeugt wird und das Flipflop F wieder zurückgesetzt wird. In diesem Erwartungszeitraum tritt zum Zeitpunkt t4 ein Rechtecksignal EM auf, da das Eingangssignal E den Schwellenwert BSN unterschreitet. Dieses Rechtecksignal ist zum Zeitpunkt t5 beendet. Es wird über das UND-Glied G1 Ausgangssignal A abgegeben.

Zwischen den Zeitpunkten t7 und t11 wiederholen sich ähnliche Vorgänge wie zwischen den Zeitpunkten t1 und t6, jedoch tritt das Rechtecksignal EM zum Zeitpunkt t8 zu früh, d. h. vor dem Erwartungszeitraum t11-t10 auf, so daß kein Ausgangssignal A erzeugt wird.

Die nächsten Rechtecksignale EP treten erst wieder zum Zeitpunkt t12 auf, da die dazwischenliegenden Eingangssignale E die Schwellenwerte BSP bzw. BNS nicht über- bzw. unterschreiten. Zwischen den Zeitpunkten t12 und t13 wiederholen sich ähnliche Vorgänge wie zwischen den Zeitpunkten t7 und t11, jedoch mit dem Unterschied, daß zum Zeitpunkt t13 ein Rechtecksignal EP ebenfalls zu früh auftritt und bereits zu diesem Zeitpunkt den Kondensator C entlädt. Auch hier wird kein Ausgangssignal A erzeugt, da das Rechtecksignal EM nicht während des Erwartungszeitraums auftritt.

Zwischen den Zeitpunkten t13 und t14 wiederholen sich wieder dieselben Vorgänge wie zwischen den Zeitpunkten t1 und t6 und es wird wieder ein Ausgangssignal A erzeugt.

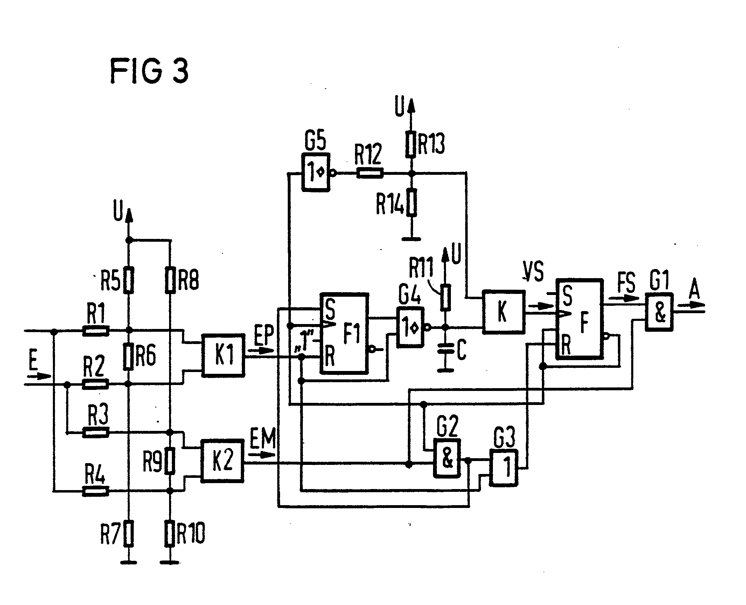

Bei dem in der Fig. 3 dargestellten Schaltbild bilden die Komparatoren K1 und K2 mit den Widerständen R1 bis R10 die beiden Bewertungsstufen B1 und B2. Zusätzlich zu dem in Fig. 1 dargestellten Blockschaltbild sind noch ein Flipflop F1 und ein UND-Glied G2 und ein ODER-Glied G3 vorgesehen, die dazu dienen, die Funktion noch weiter zu verbessern und die Schaltungsanordnung sofort wieder in einen Anfangszustand zu bringen, wenn ein Rechtecksignal EM auftritt, ohne daß das Signal FS den Binärwert 1 angenommen hat. Es wird dadurch vermieden, daß fehlerhafterweise ein Ausgangssignal A erzeugt wird, wenn kurz nach dem Auftreten eines Rechtecksignals EP mehrere Rechtecksignale EM auftreten, wovon eines zufällig zeitlich mit dem aktiven Signal FS zusammenfällt. Auch wird insbesondere durch das ODER-Glied G3 gewährleistet, daß immer das letzte eintreffende Rechtecksignal EP als gültig bewertet wird.

Die Stromquelle ST wird aus einem an der Spannungsquelle U angeschlossenen Widerstand R11 gebildet. Der Schalter S1 wird durch ein Verknüpfungsglied G4 dargestellt, das als integriertes Verknüpfungsglied ausgebildet ist und dessen Ausgangstransistor keinen Kollektorwiderstand aufweist. Dieser Kollektorwiderstand wird durch den Widerstand R11 gebildet. Die Schaltstufe S2 wird aus einem Verknüpfungsglied G5 und drei Widerständen R12 bis R14 gebildet. Das Verknüpfungsglied G5 ist ebenfalls als integriertes Verknüpfungsglied ausgebildet, dessen Ausgangstransistor keinen Kollektorwiderstand aufweist. Die Widerstände R13 und R14 bilden einen umschaltbaren Spannungsteiler, dessen Widerständen R13 bzw. R14 der Widerstand R12 parallelschaltbar ist.

Falls es die Folgefrequenz der Eingangssignale E zuläßt, kann die Schaltungsanordnung auch ausschließlich aus digitalen Bauelementen aufgebaut werden. In diesem Fall wird das Integrierglied I aus einem Zähler gebildet, der durch einen entsprechend hochfrequenten Takt fortgeschaltet wird. Die Schwellenwerte SW1 bzw. SW2 entsprechen dann vorgegebenen Zählerständen. Der Komparator K entspricht einem digitalen Vergleicher, der ständig den vom Zähler abgegebenen Zählerstand mit dem jeweils vorgegebenen Zählerstand vergleicht. Der Schalter S1 entspricht z. B. einem Eingang des Zählers, mit dem dieser jeweils auf seinen Ausgangswert zurückgesetzt wird.

Eine derart ausgebildete Schaltungsanordnung hat den Vorteil, daß sie vollständig als integrierte Schaltung herstellbar ist und durch einfache Änderung der Zähltaktfrequenz an unterschiedliche Bedingungen angepaßt werden kann.

**Patentansprüche**

1. Schaltungsanordnung zum Überprüfen des zeitlichen Abstands von Rechtecksignalen, bei der die Rechtecksignale erste Rechtecksignale (EP) und zwischen diesen auftretende zweite Rechtecksignale (EM) enthalten, bei der ein durch jeweils ein erstes Rechtecksignal ausgelöstes Zeitglied (S1, ST, I), das einen Erwartungszeitraum für jeweils ein zweites Rechtecksignal definiert, sowie eine Ausgangsstufe (F, G1) vorgesehen sind, die Ausgangssignale (A) erzeugt, wenn die zweiten Rechtecksignale während des Erwartungszeitraums auftreten, dadurch gekennzeichnet, daß das Zeitglied als ein durch eine Konstantstromquelle (ST) angesteuertes Integrierglied (I) ausgebildet ist, das nach dem Auftreten der ersten Rechtecksignale (EP) entladen und anschließend aufgeladen wird und daß eine Schaltstufe (S2), die zu Beginn bzw. am Ende des Erwartungszeitraums einen niedrigen ersten Schwellenwert (SW1) bzw. einen hohen zweiten Schwellenwert (SW2) erzeugt, und ein Komparator (K) vorgesehen sind, der die Schwellenwerte (SW1, SW2) mit der Spannung (AS) am Integrierglied (I) vergleicht und dessen Ausgangssignal (VS) der Ausgangsstufe (F, G1) zugeführt wird.

2. Schaltungsanordnung nach Anspruch 1, dadurch gekennzeichnet, daß die Ausgangsstufe ein Flipflop (F) und ein UND-Glied (G1), daß das Flipflop (F) enthält, gesetzt bzw. zurückgesetzt wird, wenn die Spannung (AS) am Integrierglied (I) den ersten bzw. zweiten Schwellenwert (SW1 bzw. SW2) überschreitet und daß das Flipflop (F) ein dem Erwartungszeitraum zugeordnetes Signal (FS) einerseits an die Schaltstufe (S2) und andererseits an ein UND-Glied (G1) abgibt, das dieses Signal (FS) mit den zweiten Rechtecksignalen (EM) verknüpft und die Ausgangssignale (A) erzeugt.

3. Schaltungsanordnung nach Anspruch 1 oder Anspruch 2, dadurch gekennzeichnet, daß die Schaltstufe (S2) als umschaltbarer Spannungsteiler (R13, R14) ausgebildet ist, an dessen Mittenabgriff die Schwellenwerte (SW1, SW2) abgegeben werden.

4. Schaltungsanordnung nach Anspruch 3, dadurch gekennzeichnet, daß die Schaltstufe (S2) als Umschalter ein integriertes binäres Verknüpfungsglied (G5) enthält, dessen Ausgangstransistor keinen Kollektorwiderstand enthält und daß der Kollektorwiderstand aus mindestens einem Widerstand (R12, R13) des Spannungsteilers gebildet wird.

5. Schaltungsanordnung nach einem der Ansprüche 1 bis 4, dadurch gekennzeichnet, daß das Integrierglied (I) einen Kondensator (C) enthält, der durch eine Stromquelle (ST), die als ein an einer Spannungsquelle (U) angeschlossener Widerstand (R11) ausgebildet ist, aufgeladen wird und der unter Verwendung eines Schalters (S1) durch die ersten Rechtecksignale (EP) entladen wird.

6. Schaltungsanordnung nach Anspruch 5, dadurch gekennzeichnet, daß als Schalter (S1) ein integriertes binäres Verknüpfungsglied (G4) vorgesehen ist, dessen Ausgangstransistor keinen Kollektorwiderstand aufweist und daß als Kollektorwiderstand der Widerstand (R11) der Konstantstromquelle (ST) vorgesehen ist.

**Claims**

1. A circuit arrangement for checking the interval of time between rectangular signals, where the rectangular signals comprise first rectangular signals (EP) and second rectangular signals (EM) which occur between the first rectangular signals, where a timer (S1, ST, I) is provided which defines an expectancy time period for a second rectangular signal in each case, and an output stage (F, G1) is provided which generates output signals (A) when the second rectangular signals occur during the expectancy time period, characterised in that the timer consists of an integrating component (I) driven by a constant current source (ST) and discharged and then charged following the occurrence of the first rectangular signals (EP), and that a switching stage (S2) is provided which produces a low first thershold value (SW1) and a high second threshold value (SW2) respectively at the beginning and at the end of the expectancy time period, and that a comparator (K) is provided which compares the threshold value (SW1, SW2) with the voltage (AS) connected to the integrating element (I) and whose output signal (VS) is supplied to the output stage (F, G1).

2. A circuit arrangement as claimed in Claim 1, characterised in that the output stage comprises a flip-flop (F) and an AND-gate (G1), that the flip-flop (F) is respectively set and reset when the voltage (AS) across the integrating element (I) exceeds the first threshold value (SW1) and the second threshold value (SW2), and that the flip-flop (F) emits a signal (FS), assigned to the expectancy time period to the switching stage (S2) on the one hand, and on the other hand to an AND-gate (G1) which logic-links this signal (FS) with the second rectangular signals (EM) and produces the output signals (A).

3. A circuit arrangement as claimed in Claim 1 or 2, characterised in that the switching stage (S2) consists of a switch-over voltage divider (R13, R14) from whose central tapping the threshold values (SW1, SW2) are emitted.

4. A circuit arrangement as claimed in Claim 3, characterised in that the switching gate (S2) comprises as change-over switch an integrated binary logic-linking element (G5) whose output includes no collector-resistance, and that the collector-resistor is formed by at least one resistor (R12, R13) of the voltage divider.

5. A circuit arrangement as claimed in one of Claims 1 to 4, characterised in that the integrating component (I) includes a capacitor (C) charged by a current source (ST) in the form of a resistor (R11) connected to a voltage source (U), and discharged by the first rectangular signals (EP) using a switch (S1).

6. A circuit arrangement as claimed in Claim 5, characterised in that the switch (S1) is in the form of an intergrated binary logic-linking element (G4) whose output transistor includes no collector-resistance, and that the resistor (R11) of the constant current (ST) serves as a collector-resistor.

**Revendications**

1. Montage pour contrôler l'intervalle de temps entre des signaux rectangulaires, montage dans lequel les signaux rectangulaires comportent des premiers signaux rectangulaires (EP) et des seconds signaux rectangulaires (EM) apparaissant entre ceux-ci, dans lequel sont prévus un élément à temps (S1, ST, I), déclenché par un premier signal rectangulaire et qui définit un laps de temps prévu pour un second signal rectangulaire, ainsi qu'un étage de sortie (F, G1) qui produit des signaux de sortie (A) lorsque les seconds signaux rectangulaires apparaissent pendant le laps de temps prévu, caractérisé en ce que l'élément à temps est réalisé comme un élément d'intégration (I) attaqué par une source de courant constant (ST) et qui est déchargé après l'apparition des premiers signaux rectangulaires (EP) et est chargé ensuite, et en ce qu'il est prévu un étage de commutation (S2) produisant au début du laps de temps prévu un premier seuil bas (SW1) et produisant à la fin du laps de temps prévu un second seuil élevé (SW2), de même qu'un comparateur (K) qui compare les seuils (SW1, SW2) avec la tension (AS) sur l'élément d'intégration (I) et dont le signal de sortie (VS est appliqué à l'étage de sortie (F, G1).

2. Montage selon la revendication 1, caractérisé en ce que l'étage de sortie comporte une bascule (F) et un élément ET (G1), que la bascule (F) est mise à 1 respectivement remise à 0 lorsque la tension (AS) sur l'élément d'intégration (I) dépasse le premier seuil (SW1) respectivement le second seuil (SW2) et que la bascule (F) délivre un signal (FS), qui est coordoné au laps de temps prévu, d'une part à l'étage de commutation (S2) et d'autre part à un élément ET (G1) qui effectue la combinaison de ce signal (FS) avec les seconds signaux rectangulaires (EM) et produit les signaux de sortie (A).

3. Montage selon la revendication 1 ou 2, caractérisé en ce que l'étage de commutation (S2) est réalisé comme un diviseur de tension (R13, R14) commutable, sur la prise médiane duquel sont délivrés les seuils (SW1, SW2).

4. Montage selon la revendication 3, caractérisé en ce que l'étage de commutation (S2) contient, en tant que commutateur, un élément logique binaire (G5) qui est intégré et dont le transistor de sortie ne contient pas de résistance de collecteur, et que la résistance de collecteur est formée d'au moins une résistance (R12, R13) du diviseur de tension.

5. Montage selon une des revendications 1 à 4, caractérisé en ce que l'élément d'intégration (I) contient un condensateur (C) qui est chargé par une source de courant (ST) réalisée comme une résistance (R11) branchée sur une source de tension (U), le condensateur étant déchargé par les premiers signaux rectangulaires (EP) au moyen d'un interrupteur (S1).

6. Montage selon la revendication 5, caractérisé en ce qu'il comporte, en tant qu'interrupteur (S1), un élément logique binaire (G4), qui est intégré et dont le transistor de sortie ne présente pas de résistance de collecteur, et que la résistance (R11) de la source de courant constant (ST) est prévue en tant que résistance de collecteur.

# FIG 1

SW1 → S2
ST
SW2
SW
K
VS
F
FS
G1 → A
AS
I C
E
B 1 → EP
S1
EP
B 2
EM

# FIG 2

BSP
E
BSN
EP
EM
SW2
AS
SW1
SW
VS
FS
A

t0 t1 t2 t3 t4 t5 t6 t7 t8 t9 t10 t11 t12 t13 t → t14

# FIG 3